Europäisches Patentamt

European Patent Office

Office européen des brevets

(19)

(11) Veröffentlichungsnummer : **0 043 407**

**B1**

(12)

# EUROPÄISCHE PATENTSCHRIFT

(45) Veröffentlichungstag der Patentschrift :
09.10.85

(51) Int. Cl.⁴ : **G 01 R 25/08, H 03 L 7/12, H 04 N 5/04**

(21) Anmeldenummer : 81102602.0

(22) Anmeldetag : 07.04.81

(54) Schaltungsanordnung zur digitalen Phasendifferenz-Messung.

(30) Priorität : 04.07.80 DE 3025356

(43) Veröffentlichungstag der Anmeldung :
13.01.82 Patentblatt 82/02

(45) Bekanntmachung des Hinweises auf die Patenterteilung : 09.10.85 Patentblatt 85/41

(84) Benannte Vertragsstaaten :
DE FR GB IT NL

(56) Entgegenhaltungen :
DD-A-   146 212
DE-A- 2 709 270
DE-A- 2 733 890
DE-A- 2 847 108
FR-A- 2 281 573
FR-A- 2 396 979

(73) Patentinhaber : Deutsche ITT Industries GmbH
Hans-Bunte-Strasse 19 Postfach 840
D-7800 Freiburg (DE)
DE
ITT INDUSTRIES INC.
320 Park Avenue
New York, NY 10022 (US)
FR GB IT NL

(72) Erfinder : Elmis, Herbert, Ing. grad.
Berliner Strasse 86
D-7809 Denzlingen (DE)

(74) Vertreter : Morstadt, Volker, Dipl.-Ing.
c/o Deutsche ITT Industries GmbH Patent/Lizenz-
abteilung Postfach 840 Hans-Bunte-Strasse 19
D-7800 Freiburg/Brsg. (DE)

EP 0 043 407 B1

Jouve, 18, rue St-Denis, 75001 Paris, France

## Beschreibung

Die Erfindung bezieht sich auf eine Schaltungsanordnung zur digitalen Messung der Phasendifferenz zwischen einer, insbesondere gesendeten, Referenzimpulsfolge und einer Impulsfolge, entsprechend dem Oberbegriff des Anspruchs 1.

Eine derartige Schaltungsanordnung ist in der FR-A-22 81 573 beschrieben. Bei dieser vorbeschriebenen Anordnung wird mittels zweier UND-Glieder mit je drei Eingängen, zweier Vorwärtszähler und eines Frequenzteilers sowie weiterer Teilschaltungen, z. B. eines Taktoszillators, die Phasendifferenz zwischen einem Signal am Eingang einer eine Verzögerung bewirkenden Stufe (dort als zu testende Schaltung bezeichnet) und dem Ausgangssignal dieser Stufe gemessen, wobei die Frequenz des Taktoszillators als Bezugsgröße dient. Das unverzögerte Signal ist mit der Impulsfolge nach der Erfindung insoweit vergleichbar, als bei der vorbeschriebenen Anordnung ebenso wie bei der Erfindung dieses Signal dem einen Eingang des einen UND-Glieds zugeführt ist, während das verzögerte Signal, für das es bei der Erfindung keinen Vergleichspartner gibt, über ein weiteres UND-Glied, das bei der Erfindung ebenfalls fehlt, dem zweiten UND-Glied zugeführt ist.

Die Erfindung läßt sich mit besonders großem Vorteil bei der Synchronisierung der Horizontalablenkung von Fernsehgeräten anwenden. In diesem Falle ist die Referenzimpulsfolge durch die gesendeten Horizontalsynchronimpulse repräsentiert, die bekanntlich im Fernsehgerät aus dem Bild-Amplituden-Synchron-Signal-Gemisch in bekannter Weise separiert werden. Aber auch bei den sogenannten phasenverriegelten Oszillatorschaltungen, wie sie beispielsweise zur Frequenzsynthese verwendet werden, spielt die Phasendifferenzmessung eine Rolle. Derartige phasenverriegelte Oszillatoren bestehen aus dem in seiner Frequenz regelbaren Oszillator, der Meßschaltung für die Phasendifferenz zwischen dem Oszillatorsignal und einem Referenzsignal sowie einer Filterschaltung zur Aufbereitung des Regelsignals für den Oszillator. Um die oft aufwendigen Filterschaltungen zu vermeiden, ist es möglich, die digital gemessenen Phasendifferenzen nicht analog, z. B. durch RC-Glieder, zu verarbeiten, sondern durch Verwendung eines in seinem Teilerverhältnis einstellbaren Frequenzteilers direkt in Frequenz- bzw. Phasenänderungen umzusetzen. Hierzu ist Voraussetzung, daß die Frequenz eines nunmehr verwendeten und in seiner Frequenz umgesteuerten Oszillators so groß ist, daß die kleinstmögliche Phasenänderung kleiner ist als die zulässige Phasenabweichung des Ausgangssignals der phasenverriegelten Oszillatorschaltungen. Dabei kann der eigentliche Phasenvergleich in Phasen- und Frequenzmessung aufgeteilt sein.

Die zwangsläufig immer vorhandenen, dem Referenzsignal überlagerten Rauschimpulse und Störsignale verfälschen dabei jedoch die Phasendifferenzmessung.

Die Aufgabe der im Anspruch 1 bzw. im Anspruch 4 angegebenen Erfindung besteht daher darin, eine digitale Phasendifferenz-Meßschaltung der eingangs genannten Art anzugeben, die auch dann genaue Meßwerte liefert, wenn in der Referenzimpulsfolge statistisch verteilte Störsignale bzw. Rauschimpulse auftreten, und die keine stör- oder rauschimpulsbedingte Einschränkung des Meßbereichs aufweist.

Weiterbildungen sind in den Ansprüchen 2 und 3 angegeben.

Die Erfindung wird nun anhand der Figuren der Zeichnung näher erläutert.

Figur 1 zeigt schematisch in Form eines Blockschaltbilds ein Ausführungsbeispiel der Erfindung und

Figur 2 zeigt schematisch in Form eines Blockschaltbilds eine Schaltungsanordnung zur Synchronisierung entsprechend Anspruch 3.

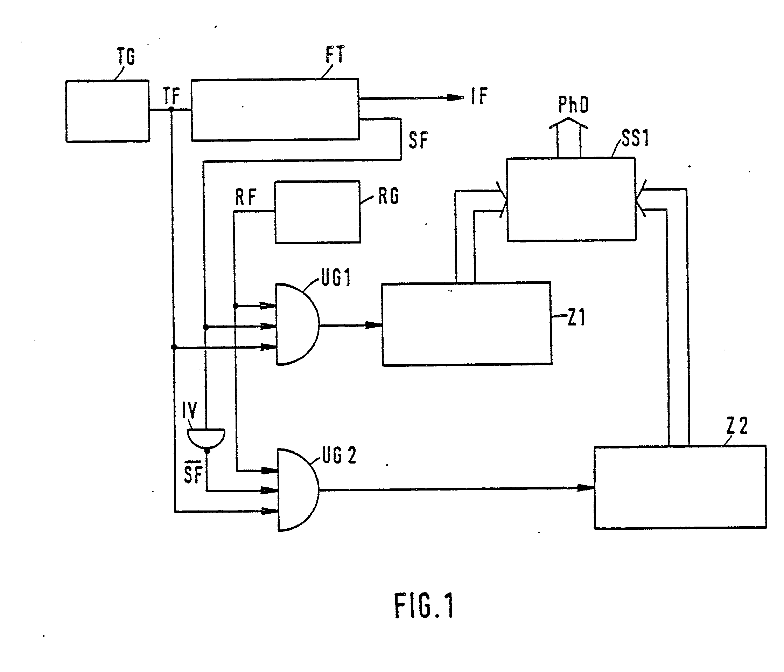

Das Blockschaltbild nach Fig. 1 zeigt den Taktgenerator TG für das Taktsignal TF, das dem Eingang des Frequenzteilers FT zugeführt ist. Am Ausgang des Frequenzteilers FT entsteht die Impulsfolge IF, deren Phasendifferenz bezüglich der Referenzimpulsfolge RF gemessen werden soll. Diese wird vom Referenzimpuls-Generator RG erzeugt, der beispielsweise die Horizontalsynchronimpuls-Abtrennschaltung eines Fernsehgerätes sein kann.

Vom Frequenzteiler FT ist außer der Impulsfolge IF noch das Schaltsignal SF abgeleitet, das die doppelte Frequenz wie die Referenzimpulsfolge RF und ein Puls-Pausen-Verhältnis von 1 : 1 hat.

Den drei Eingängen des ersten UND-Gliedes UG1 und den drei Eingängen des zweiten UND-Gliedes UG2 sind jeweils das Taktsignal TF bzw. die Referenzimpulsfolge RF bzw. das Schaltsignal $\overline{SF}$ (UND-Glied UG1) oder das über die Inverterstufe IV invertierte Schaltsignal $\overline{SF}$ (UND-Glied UG2) zugeführt. Die Ausgänge der beiden UND-Glieder UG1, UG2 liegen jeweils am Zähleingang des ersten bzw. des zweiten Vorwärtszählers Z1, Z2, deren Ausgänge mit den Eingängen der Subtrahierschaltung SS1 verbunden sind. Wie in Fig. 1 durch die bandförmige Leitungsführung zwischen den beiden Vorwärtszählern Z1, Z2 und der Subtrahierschaltung SS1 angedeutet ist, handelt es sich bei dieser Verbindung um die Parallelübertragung von Digitalsignalen, d. h. die jeweiligen Zählerstände der beiden Vorwärtszähler Z1, Z2 werden in paralleler Form an die zugeordneten Eingänge der Subtrahierschaltung SS1 weitergegeben, an deren Ausgang das Phasendifferenz-Digitalsignal PhD abgenommen werden kann.

Die beiden Vorwärtszähler Z1, Z2 zählen somit jeweils während aufeinanderfolgender Halbperioden des Teilerausgangssignals (Impulsfolge) IF die während der Referenzimpulsdauer und während der Dauer von Stör- oder Rauschimpulsen auftretenden Impulse des Taktsignals TF. Aufgrund der in der Subtrahierschaltung SS1 erfolgenden Differenzbildung wird über jeweils eine Referenzimpulsperiode gemittelt. Die Phasendifferenz wird somit zu null, wenn die Flanken des Schaltsignals SF in der Mitte der Impulse des Referenzsignals RF auftreten. Wenn statistisch verteilte Stör- oder Rauschimpulse auftreten, bleibt die Phasendifferenz annähernd gleich null oder schwankt bei niederfrequenten Störungen um den jeweils gemessenen Phasendifferenzwert.

Ohne Einschränkung des Meßbereichs ist es also möglich, über die gesamte Periode des Referenzsignals die Phasendifferenz zu messen.

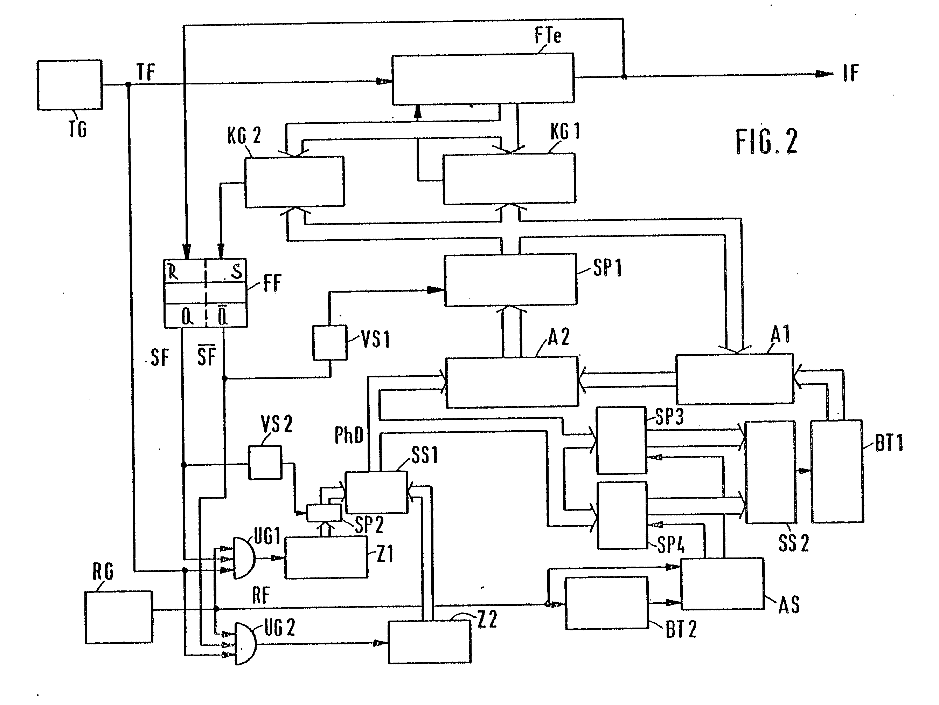

Im Blockschaltbild nach Fig. 2 wird die gemessene Phasendifferenz zur Frequenzkorrektur, d. h. zur bleibenden Änderung des Teilerverhältnisses des Frequenzteilers FT herangezogen. Somit ist eine Synchronisierung der Impulsfolge IF durch die Referenzimpulsfolge RF möglich. Dies geschieht im wesentlichen dadurch, daß die gemessenen Phasendifferenzen über eine größere Anzahl von Periodendauern der Referenzimpulsfolge zeitlich gemittelt werden, woraus sich die Frequenzabweichung ergibt.

In Fig. 2 ist somit der erwähnte einstellbare Frequenzteiler als m-stufiger Binärteiler FTe ausgeführt, wobei m ganzzahlig ist. Der Binärteiler FTe hat einen Rücksetzeingang, so daß er vor Erreichen seines Endzustandes von neuem zu zählen beginnen kann, d. h., mittels eines Signals am Rücksetzeingang kann das Teilerverhältnis in einfacher Weise eingestellt werden. Im Sinne der Erfindung können jedoch auch auf andere Art und Weise einstellbare Frequenzteiler verwendet werden ; beispielsweise können Vorwahlzähler verwendet werden, die in Abhängigkeit von der gemessenen Phasendifferenz auf bestimmte Zählerstände eingestellt werden.

Die Anzahl der Periodendauern der Referenzimpulsfolge RF, über die die Phasendifferenz PhD gemittelt wird, ist gleich einer n-ten Zweierpotenz, wobei n ganzzahlig und mindestens gleich fünf ist. Hierzu wird mittels des n-stufigen zweiten Binärteilers BT2 der eine Eingang der Ablaufsteuerung AS angesteuert, an deren anderem Eingang die Referenzimpulsfolge RF liegt. Die Ablaufsteuerung und der zweite Binärteiler BT2 erzeugen während der Dauer eines Zählerumlaufs einen Impuls dieser Dauer und daraus jeweils einen kurzen, mit der Vorder- bzw. Rückflanke synchronen Impuls. Diese beiden Impulse liegen am jeweiligen Übernahmeeingang des dritten und des vierten Speichers SP3, SP4, deren Eingängen das Phasendifferenz-Digitalsignal PhD zugeführt ist. Somit wird zu Beginn eines Umlaufs des Binärteilers BT2 der momentane Phasendifferenzwert in den dritten Speicher SP3 übernommen und ebenso der am Ende des Teilerumlaufs auftretende Momentanwert in den vierten Speicher SP4. Diese beiden Momentanwerte werden in der Subtrahierstufe SS2 voneinander subtrahiert, deren Ausgangsbinärwerte im n-stufigen Binärteiler BT1 durch Weglassen der letzten n niedrigstwertigen Stellen durch die Zahn $2^n$ geteilt werden. An dessen Ausgang entsteht somit ein Signal bezüglich der mittleren Phasendifferenz während der Dauer des Umlaufs des zweiten Binärteilers BT2, der ebenfalls n-stufig ist. Diese mittlere Phasendifferenz stellt aber die Frequenzabweichung dar. Das entsprechende Digitalsignal am Ausgang des n-stufigen Binärteilers BT1 wird somit den einen Eingängen des ersten Addierers A1 zugeführt, an dessen anderen Eingängen das im ersten Speicher SP1 jeweils enthaltene Digitalsignal liegt. Sein Ausgangssignal ist den einen Eingängen des zweiten Addierers A2 zugeführt, an dessen anderen Eingängen das Phasendifferenzsignal PhD liegt und dessen Ausgangssignal den Eingängen des ersten Speichers SP1 zugeführt ist.

Der Ausgang des ersten Speichers SP1 ist ferner mit den einen Eingängen des ersten Koinzidenzgatters KG1 verbunden, dessen andere Eingänge an den Zählerstandausgängen des einstellbaren Frequenzteilers FTe liegen und dessen Ausgang am Rücksetzeingang des einstellbaren Frequenzteilers liegt. Wenn also der Speicherinhalt des ersten Speichers SP1 und der Zählerstand des einstellbaren Frequenzteilers FTe einander gleich sind, erfolgt das Rücksetzsignal für ihn. Der Speicherinhalt bestimmt also den Teilungsfaktor des Frequenzteilers FTe.

Der Ausgang des ersten Speichers SP1 ist ferner mit den einen Eingängen des zweiten Koinzidenzgatters KG2 verbunden, allerdings so, daß das gespeicherte Binärwort ohne dessen niedrigstwertige Stelle (least significant bit) zum zweiten Koinzidenzgatter KG2 gelangt. An dessen anderen Eingängen liegen die Ausgangssignale von m Stufen des einstellbaren Frequenzteilers FTe, d. h., die Ausgangssignale des Frequenzteilers FTe werden mit dem durch zwei geteilten Binärwort des Speichers SP1 im Koinzidenzgatter KG2 verglichen.

Der Ausgang des zweiten Koinzidenzgatters KG2 liegt am S-Eingang und der Ausgang der letzten Frequenzteilerstufe liegt am R-Eingang des RS-Flipflops FF, an dessen Q- bzw. $\overline{Q}$-Ausgang das Schaltsignal SF bzw. das dazu invertierte Schaltsignal $\overline{SF}$ entstehen. Durch die Unterdrückung der niedrigstwertigen Stelle des Speicherinhalts des ersten Speichers SP1 und des Zählerstandes des einstellbaren Frequenzteilers FTe wird in Verbindung mit dem RS-Flipflop FF also die Bedingung erfüllt, das das Schaltsignal die doppelte Frequenz wie das Ausgangssignal IF und das Puls-Pausen-Verhältnis 1 : 1 haben muß.

Der Übernahmeeingang des ersten Speichers SP1 ist über die erste Verzögerungsstufe VS1 mit dem $\overline{Q}$-Ausgang des RS-Flipflops FF verbunden. Die Verzögerungszeit ist dabei so gewählt, daß nach einigen Taktimpulsen des Taktsignals TF das Ausgangssignal des zweiten Addierers A2 in den ersten Speicher SP1 übernommen wird.

In die Verbindungsleitungen zwischen dem Ausgang des ersten Vorwärtszählers Z1 und den zugeordneten Eingängen der Subtrahierschaltung SS1 ist ferner der zweite Speicher SP2 eingefügt, an dessen Übernahmeeingang der Q-Ausgang des RS-Flipflops FF unter Zwischenschaltung der zweiten Verzögerungsstufe VS2 angeschlossen ist. Deren Verzögerungzeit ist größer als die der ersten Verzögerungsstufe VS1.

Bei einer Abwandlung der in Anspruch 1 angegebenen Erfindung (vgl. Anspruch 4), kann anstatt des ersten und des zweiten Vorwärtszähler Z1, Z2 ein einziger Vorwärts-Rückwärtszähler vorgesehen werden, der abwechselnd während jeweils einer Periodendauer der Impulsfolge IF in Vorwärts- bzw. Rückwärtsrichtung zählt. Der Einsatz eines Vorwärts-Rückwärtszählers bei der Phasendifferenzmessung einer Impulsfolge ist an sich in der DE-A-28 47 108 vorbeschrieben.

Die Erfindung hat unter anderem den Vorteil, daß sie mit ausschließlich digitalen Teil- und Grundschaltungen realisiert werden kann, was insbesondere ihre Integrierung in der Technik der Isolierschicht-Feldeffekttransistoren, also der sogenannten MOS-Technik, ermöglicht. Auch die Weiterbildung nach Fig. 2 als Synchronisierschaltung zur bevorzugten Anwendung in Fernsehgeräten läßt sich ohne weiteres in MOS-Technik integrieren, da dort ebenfalls lediglich digitale Teil- und Grundschaltungen erforderlich sind.

Es ist jedoch auch ohne weiteres möglich, bipolare Schaltungskonzepte zur Integrierung heranzuziehen, insbesondere solche, die sich für Digitalschaltungen eignen, wie z. B. die sogenannte integrierte Injektionslogik-Schaltungstechnik (I²L-Schaltungen).

Ein weiterer Vorteil der Erfindung besteht darin, daß sie, insbesondere was die erwähnte Weiterbildung angeht, dem immer größer werdenden Trend gerecht wird, in Fernsehgeräten bisher übliche Techniken der analogen Signalaufbereitung durch digitale Techniken zu ersetzen. Die erwähnte Weiterbildung stellt im Gegensatz zu den bisher üblichen analogen Horizontal-Synchronisierschaltungen eine derartige digitale Horizontal-Synchronisierschaltung neuer Art dar.

## Patentansprüche

1. Schaltungsanordnung zur digitalen Messung der Phasendifferenz zwischen einer, insbesondere gesendeten, Referenzimpulsfolge (RF) und einer Impulsfolge (IF),
— mit einem ersten und einem zweiten UND-Glied (UG1, UG2) mit je drei Eingängen,
— mit einem ersten und einem zweiten Vorwärtszähler (Z1, Z2), deren jeweiliger Zähleingang am Ausgang des ersten bzw. zweiten UND-Glieds (UG1, UG2) liegt und deren Ausgänge an den Eingängen einer das Phasendifferenz-Digitalsignal (PhD) abgebenden Ausgangsschaltung angeschlossen sind, und
— mit einem Frequenzteiler (FT), dessen Eingang ein Taktsignal (TF) zugeführt ist, wobei dem ersten Eingang des ersten UND-Glieds (UG1) ein Schaltsignal (SF) zugeführt ist, gekennzeichnet durch folgende Merkmale :
— die Impulsfolge (IF) ist das Ausgangssignal des Frequenzteilers (FT) und hat eine um mindestens eine Größenordnung kleinere Frequenz als das Taktsignal (TF) ;
— das Schaltsignal (SF) ist vom Frequenzteiler (FT) abgeleitet und hat die doppelte Frequenz wie die Referenzimpulsfolge (RF) und ein Puls-Pausen-Verhältnis von 1 : 1,
— dem ersten Eingang des zweiten UND-Glieds (UG2) ist das invertierte vom Frequenzteiler (FT) abgeleitete Schaltsignal ($\overline{SF}$) zugeführt,
— dem jeweils zweiten bzw. dritten Eingang des ersten und des zweiten UND-Glieds (UG1, UG2) ist die Referenzimpulsfolge (RF) bzw. das Taktsignal (TF) zugeführt, und
— die Ausgangsschaltung ist eine Subtrahierschaltung (SS1).

2. Schaltungsanordnung nach Anspruch 1 zur Synchronisierung der Impulsfolge (IF) mit der Referenzimpulsfolge (RF), dadurch gekennzeichnet, daß der Frequenzteiler (FT) ein einstellbarer Frequenzteiler (FTe) ist und sein Teilerverhältnis in Abhängigkeit von der über eine Mittelungszeit gemittelten Phasendifferenz eingestellt wird und die Mittelungszeit gleich einer größeren Anzahl von Periodendauern der Referenzimpulsfolge (RF) ist.

3. Schaltungsanordnung nach Anspruch 2, gekennzeichnet durch folgende Merkmale :
— der einstellbare Frequenzteiler (FTe) ist ein m-stufiger Binärteiler, wobei m eine ganze Zahl ist,
— die Anzahl der Periodendauern ist gleich einer n-ten Zweier-Potenz, wobei n eine ganze Zahl und mindestens gleich fünf ist,
— die zu Beginn und die am Ende der Mittelungszeit gemessenen beiden momentanen Phasendifferenz-Digitalsignale sind einer zweiten Subtrahierstufe (SS2) zugeführt, deren Ausgang über einen ersten n-stufigen Binärteiler (BT1) am einen Eingang eines ersten Addierers (A1) liegt,
— das Phasendifferenz-Digitalsignal (PhD) liegt am einen Eingang eines zweiten Addierers (A2), dessen anderer Eingang mit dem Ausgang des ersten Addierers (A1) verbunden und dessen Ausgangssignal einem ersten Speicher (SP1) zugeführt ist,
— der Ausgang des ersten Speichers (SP1) ist mit dem anderen Eingang des ersten Addierers (A1) und mit den einen Eingängen eines ersten Koinzidenzgatters (KG1) verbunden, dessen andere Eingänge an den Zählerstandausgängen des einstellbaren Frequenzteilers (FTe) liegen und dessen Ausgang am Rücksetzeingang des einstellbaren Frequenzteilers (FTe) liegt,
— den einen Eingängen eines zweiten Koinzidenzgatters (KG2) ist das im ersten Speicher (SP1) enthaltene Binärwort ohne dessen niedrigstwertige Stelle und den anderen Eingängen des Gatters (KG2) sind die Ausgangssignale des einstellbaren Frequenzteilers (FTe) zugeführt,
— der Ausgang des zweiten Koinzidenzgatters (KG2) liegt am S-Eingang und der Ausgang der letzten Frequenzteilerstufe am R-Eingang eines RS-Flipflops (FF), an dessen Q- bzw. Q̄-Ausgang das Schaltsignal (SF) bzw. das invertierte Schaltsignal (S̄F̄) entsteht,
— der Übernahmeeingang des ersten Speichers (SP1) ist über eine erste Verzögerungsstufe (VS1) mit dem Q̄-Ausgang des RS-Flipflops (FF) verbunden und
— der Ausgang des ersten Vorwärtszählers (Z1) liegt über einen zweiten Speicher (SP2) an der Subtrahierschaltung (SS1), an dessen Übernahmeeingang der Q-Ausgang des RS-Flipflops (FF) unter Zwischenschaltung einer zweiten Verzögerungsstufe (VS2) angeschlossen ist.

4. Schaltungsanordnung nach Anspruch 1 oder 3, dadurch gekennzeichnet, daß anstatt des ersten und des zweiten Vorwärtszählers (Z1, Z2) ein einziger Vorwärts-Rückwärtszähler vorgesehen ist, der abwechselnd während jeweils einer Periodendauer der Impulsfolge (IF) in Vorwärts- bzw. Rückwärtsrichtung zählt.

## Claims

1. Digitalized phase difference measuring circuit for measuring the phase difference between a sequence of reference pulses (RF), in particular a transmitted one, and a pulse sequence (IF),
— comprising a first and a second AND gate (UG1, UG2) each having three inputs,
— comprising a first and a second forward counter (Z1, Z2) whose respective counting inputs are applied to the output of the first or the second AND gate (UG1, UG2) respectively, with the outputs thereof being connected to the inputs of an output circuit transmitting the phase difference digital signal (PhD), and
— comprising a frequency divider (FT) to the input of which a clock signal (TF) is applied, with a switching signal (SF) being applied to the first input of the first AND gate (UG1),
characterized by the following features :
— the pulse sequency (IF) is the output signal of the frequency divider (FT), and is of a frequency which is as least by one order of magnitude lower than the clock signal (TF) ;
— the switching signal (SF) is derived from the frequency divider (FT), and its frequency equals twice that of the sequence of reference pulses (RF) and has a pulse/no pulse ratio of 1 : 1,
— to the first input of the second AND gate (UG2) there is applied the inverted switching signal (S̄F̄) as derived from the frequency divider (FT),
— to the respective second or third input of the first and the second AND gate (UG1, UG2) there is applied the sequence of reference pulses (RF) or the clock signal (TF) respectively, and
— the output circuit is a subtracter (SS1).

2. A circuit as claimed in claim 1 for synchronizing the pulse sequence (IF) with the sequence of reference pulses (RF), characterized in that the frequency divider (FT) is an adjustable frequency divider (FTe) whose division ratio is adjusted in dependence upon the phase difference averaged throughout an averaging time with is equal to a larger number of periods of said sequence of reference pulses (RF).

3. A circuit as claimed in claim 2, characterized by the following features :
— the adjustable frequency divider (FTe) is an m-stage binary divider, with m being an integer,
— the number of periods is equal to one n-th power of two, with n being an integer at least equalling five,
— the two momentary phase difference digital signals as measured both at the beginning and at the end of the averaging time, are fed to a second subtracter (SS2) whose output, via a first n-stage binary divider (BT1), is applied to the one input of a first adder circuit (A1),
— the phase difference digital signal (PhD) is applied to the one input of a second adder circuit (A2), the other input switch is connected to the output of the first adder circuit (A1), and the output signal thereof is applied to a first storage device (SP1),
— the output of the first storage device (SP1) is connected to the other input of the first adder circuit (A1) and to the one type of inputs of a first coincidence gate (KG1) whose other types of inputs are applied to the counter reading outputs of the adjustable frequency divider (FTe), with the output thereof being connected to the resetting input of the adjustable frequency divider (FTe),
— to the one type of inputs of a second coincidence gate (KG2) there is fed the binary word as contained in said first storage device (SP1), without the least significant bit thereof, and to the other types of inputs of said gate (KG2) there are fed the output signals of said adjustable frequency divider (FTe),
— the output of the second coincidence gate (KG2) is applied to the S-input, and the output of the last frequency divider stage is applied to the R-input of an R-S flip-flop (FF), at the Q- or Q̄-output of which there occurs the switching signal (SF) of the inverted switching signal (S̄F̄) respectively,
— the takeover input of the first storage device (SP1) is connected to the Q̄-output of the R-S flip-flop (FF) via a first delay stage (VS1), and
— the output of the first forward counter (Z1) is applied via a second storage device (SP2), to the subtracter (SS1), to the takeover input of which there is connected the Q-output of the R-S flip-flop (FF) by the insertion of a second delay stage (VS2).

4. A circuit as claimed in claim 1 or 3, characterized in that instead of the first and the second forward counter (Z1, Z2) there is provided one single forward-backward counter which alternatingly counts either in the forward or in the backward direction during the period of the pulse sequence (IF).

## Revendications

1. Circuit de mesure numérique de la différence de phase entre un train d'impulsions de référence (RF), notamment émis, et un train d'impulsions (IF), comprenant :

— une première et une seconde porte ET (UG1, UG2) disposant chacune de trois entrées,

— un premier et un second compteur ascendant (Z1, Z2) dont les entrées de comptage respectives sont reliées à la sortie de la première ou de la seconde porte ET (UG1, UG2) et dont les sorties sont reliées aux entrées d'un circuit de sortie délivrant le signal numérique de différence de phase (PhD), et

— un diviseur de fréquence (FT) dont l'entrée reçoit un signal de synchronisation (TF), de manière que la première entrée de la première porte ET (UG1) reçoit un signal de commutation (SF), caractérisé en ce que :

— le train d'impulsions (IF) est le signal de sortie du diviseur de fréquence (FT) et possède une fréquence inférieure d'au moins un ordre de grandeur par rapport au signal de synchronisation (TF),

— le signal de commutation (SF) est dérivé du diviseur de fréquence (FT) et possède une fréquence double de celle du train d'impulsion de référence (RF) et un rapport impulsion/intervalle de 1/1,

— la première entrée de la seconde porte ET (UG2) reçoit le signal inverse $\overline{SF}$ dérivé du diviseur de fréquence (FT),

— la seconde et respectivement la troisième entrée de la première et de la seconde porte ET (UG1, UG2) reçoivent le train d'impulsions de référence (RF) et respectivement le signal de synchronisation, et

— le circuit de sortie est un circuit soustracteur (SS1).

2. Circuit conforme à la revendication 1 destiné à synchroniser le train d'impulsions (IF) avec le train d'impulsions de référence (RF), caractérisé en ce que le diviseur de fréquence (FT) est un diviseur de fréquence réglable (FTe), en ce que son rapport de division est réglé en fonction de la différence de phase moyenne calculée sur un temps d'établissement de la moyenne, égal à un plus grand nombre de périodes du train d'impulsions de référence (RF).

3. Circuit conforme à la revendication 2, caractérisé en ce que :

— le diviseur de fréquence réglable (FTe) est un diviseur binaire à m étages, m étant un nombre entier,

— le nombre des périodes est égal à une nième puissance de deux, n étant un nombre entier au moins égal à cinq,

— les deux signaux numériques instantanés de différence de phase mesurés au début et à la fin du temps d'établissement de la moyenne sont envoyés à un second étage soustracteur (SS2) dont la sortie est raccordée à une entrée d'un premier additionneur (A1) par un premier diviseur binaire à n étages (BT1),

— le signal numérique de différence de phase (PhD) est appliqué à une entrée d'un second additionneur (A2) dont l'autre entrée est reliée à la sortie du premier additionneur (A1) et dont le signal de sortie est envoyé à une première mémoire (SP1),

— la sortie de la première mémoire (SP1) est reliée à l'autre entrée du premier additionneur (A1) et à l'une des entrées d'un premier circuit à coïncidence (KG1) dont l'autre entrée est raccordée aux sorties de position de comptage du diviseur de fréquence réglable (FTe) et dont la sortie est raccordée à l'entrée de remise à l'état initial du diviseur de fréquence réglable (FTe),

— l'une des entrées d'un second circuit à coïncidence (KG2) reçoit le mot binaire contenu dans la première mémoire (SP1) sans son chiffre le moins significatif et l'autre entrée dudit circuit (KG2) reçoit les signaux de sortie du diviseur de fréquence réglable (FTe),

— la sortie du second circuit à coïncidence (KG2) est reliée à l'entrée S d'une bascule électronique RS (FF) et la sortie du dernier étage du diviseur de fréquence est reliée à l'entrée R de ladite bascule RS (FF) à la sortie Q ou $\bar{Q}$ de laquelle est produit le signal de commutation (SF) ou le signal de commutation inversé ($\overline{SF}$),

— l'entrée de réception de la première mémoire (SP1) est reliée à la sortie $\bar{Q}$ de la bascule électronique RS (FF) par un premier étage de retard (VS1), et

— la sortie du premier compteur ascendant (Z1) est reliée par une seconde mémoire (SP2) au circuit soustracteur (SS1), l'entrée de réception de cette mémoire étant raccordée à la sortie Q de la bascule électronique RS (FF), par l'intermédiaire d'un second étage de retard (VS2).

4. Circuit conforme à la revendication 1 ou 3, caractérisé en ce que, au lieu du premier et du second compteur ascendant (Z1, Z2) est prévu un seul compteur-décompteur assurant un comptage alternatif dans le sens ascendant et dans le sens descendant pendant une durée de période du train d'impulsions (IF).

0 043 407

FIG.1

FIG. 2

0 043 407